# EUROPÄISCHE PATENTSCHRIFT

(11) **EP 1 057 255 B1**
(45) Veröffentlichungstag und Bekanntmachung des Hinweises auf die Patenterteilung: **18.07.2001**
(21) Anmeldenummer: 99907512.0
(22) Anmeldetag: 05.02.1999
(51) Int. Cl.: H03F 1/30, H03F 3/343

(54) **VERFAHREN UND SCHALTUNGSANORDNUNG ZUR ÜBERTRAGUNG VON SIGNALEN**
METHOD AND CIRCUITRY FOR THE TRANSMISSION OF SIGNALS
PROCEDE ET CIRCUIT POUR LE TRANSFERT DE SIGNAUX

(30) Priorität: 21.02.1998 DE 19807393
(43) Veröffentlichungstag der Anmeldung: 06.12.2000
(73) Patentinhaber: Mannesmann VDO Aktiengesellschaft, 60388 Frankfurt am Main (DE)
(72) Erfinder: JOCH, Christoph, D-65760 Eschborn (DE)
(74) Vertreter: Klein, Thomas, Dipl.-Ing. (FH)
(86) Internationale Anmeldenummer: EP9900789
(87) Internationale Veröffentlichungsnummer: WO9943082

(56) Entgegenhaltungen:
- US-A- 3 370 244
- US-A- 3 868 582
- US-A- 4 764 733
- K.WILLE: "EIN SCHNELLER dc-VERSTÄRKER MIT STABILISIERUNG DES RUHEPOTENTIALS" NUCLEAR INSTRUMENTS AND METHODS, Bd. 72, Nr. 3, 1. August 1969, Seiten 314-316, XP002106030 AMSTERDAM NL

## Beschreibung

Die Erfindung betrifft ein Verfahren und eine Schaltungsanordnung zur Übertragung von Signalen von einem Ausgang einer ersten Schaltung zu einem Eingang einer zweiten Schaltung, wobei die Schaltungen von einer ersten und einer zweiten Betriebsspannung und einem ersten und einem zweiten Massepotential beaufschlagt sind und wobei zwischen den Massepotentialen veränderliche Potentialunterschiede auftreten können.

Bei der Übertragung von Signalen zwischen zwei Schaltungen, die zueinander einen Potentialversatz aufweisen, kann es zu Störungen der übertragenen Signale kommen. Ist beispielsweise in einem Kraftfahrzeug ein Steuergerät an einem anderen Massepunkt angeschlossen als die zugehörige Leistungsendstufe, so können erhebliche Potentialdifferenzen auftreten, so daß von dem Steuergerät zur Leistungsendstufe übertragene Signale gestört sein können. Der Potentialversatz kann sogar ein Mehrfaches der Betriebsspannung betragen, so daß selbst digitale Signale nicht mehr zuverlässig ausgewertet werden können.

Aufgabe der vorliegenden Erfindung ist es daher, ein Verfahren und eine Schaltungsanordnung zur Übertragung von Signalen anzugeben, bei welcher auftretende veränderliche Potentialunterschiede zwischen den Schaltungen nicht zu Störungen führen.

Diese Aufgabe wird bei dem erfindungsgemäßen Verfahren dadurch gelöst, daß vom Ausgang der ersten Schaltung ein von dem zu übertragenden Signal gesteuerter Strom zu einem mit einem weiteren Potential beaufschlagten Schaltungspunkt fließt und einen von dem Schaltungspunkt ausgehenden weiteren Strom steuert, der dem Eingang der zweiten Schaltung zugeführt wird, und daß das weitere Potential derart gewählt ist, daß zwischen dem Ausgang der ersten Schaltung und dem weiteren Potential einerseits und dem weiteren Potential und dem Eingang der zweiten Schaltung andererseits bei den auftretenden Potentialunterschieden jeweils eine den Strom und den weiteren Strom ermöglichende Spannung anliegt.

Bei der erfindungsgemäßen Schaltungsanordnung ist vorgesehen, daß der Ausgang der ersten Schaltung mit einer steuerbaren Stromquelle versehen ist, deren Strom in Richtung auf einen mit einem weiteren Potential beaufschlagten Schaltungspunkt fließt und eine an den Schaltungspunkt angeschlossene weitere Stromquelle steuert, deren Strom in Richtung auf den Eingang der weiteren Schaltung fließt, und daß das weitere Potential derart gewählt ist, daß zwischen dem Ausgang der ersten Schaltung und dem weiteren Potential einerseits und dem weiteren Potential und dem Eingang der zweiten Schaltung andererseits bei den auftretenden Potentialunterschieden jeweils eine den Strom und den weiteren Strom ermöglichende Spannung anliegt. Der mit der Erfindung überwindbare Potentialunterschied ist lediglich durch die zulässige Kollektor-Emitter-Spannung der die Stromquellen mindestens teilweise bildenden Transistoren begrenzt.

Ein ausreichender Stromfluß durch die Stromquellen ist gemäß einer Ausgestaltung der erfindungsgemäßen Schaltungsanordnung dadurch gewährleistet, daß das weitere Potential mindestens um die Summe aus der Emitter-Kollektor-Spannung eines die Stromquelle mindestens teilweise bildenden und mit seinem Emitter mit der ersten Betriebsspannung beaufschlagten Transistors und der Basis-Emitter-Spannung eines die weitere Stromquelle mindestens teilweise bildenden Transistors niedriger als die erste Betriebsspannung und mindestens um die Summe der Kollektor-Emitter-Spannung des die weitere Stromquelle bildenden Transistors und der Basis-Emitter-Spannung eines mit dem Eingang der zweiten Schaltung verbundenden Transistors niedriger als die zweite Betriebsspannung ist.

Bei der Verwendung von Transistoren mit einem anderen Leitfähigkeitstyp wird dies dadurch erreicht, daß das weitere Potential mindestens um die Summe aus der Emitter-Kollektor-Spannung eines die Stromquelle mindestens teilweise bildenden und mit seinem Emitter mit dem ersten Massepotential beaufschlagten Transistors und der Basis-Emitter-Spannung eines die weitere Stromquelle mindestens teilweise bildenden Transistors höher als das erste Massepotential und mindestens um die Summe der Kollektor-Emitter-Spannung des die weitere Stromquelle bildenden Transistors und der Basis-Emitter-Spannung eines mit dem Eingang der zweiten Schaltung verbundenden Transistors höher als das zweite Massepotential ist.

In weiteren Unteransprüchen aufgeführte vorteilhafte Weiterbildungen der erfindungsgemäßen Schaltungsanordnung sind auf Dimensionierungsangaben für das weitere Potential im Falle von jeweils positiven und negativen Betriebsspannungen der Schaltungen und der Verwendung von pnp- oder npn-Transistoren für die Stromquellen gerichtet.

Bei einer Weiterbildung der erfindungsgemäßen Schaltungsanordnung ist vorgesehen, daß zur Erzeugung des weiteren Potentials ein das weitere Potential führender Schaltungspunkt über je eine Diode mit den Massepotentialen bzw. den Betriebsspannungen beaufschlagt ist.

Bei einer Anwendung der erfindungsgemäßen Schaltungsanordnung im Kraftfahrzeug kann die Betriebsspannung der Leistungsendstufen enthaltenden zweiten Schaltung kurzzeitig ausfallen. Damit beim Wiedereinsetzen der Betriebsspannung die Leistungsendstufen möglichst schnell wieder angesteuert werden können, ist bei einer anderen Weiterbildung der erfindungsgemäßen Schaltungsanordnung vorgesehen, daß zur Erzeugung des weiteren Potentials ein das weitere Potential führender Schaltungspunkt über einen Kondensator und eine erste Diode mit der Betriebsspannung einer der Schaltungen und über eine zweite Diode mit dem Massepotential der anderen Schaltung verbunden ist.

Eine bevorzugte Anwendung der erfindungsgemäßen Schaltungsanordnung besteht darin, daß die erste Schaltung eine Steuerschaltung und die zweite Schaltung eine Leistungsstufe einer elektronischen Kraftfahrzeugeinrichtung ist.

Die Erfindung läßt zahlreiche Ausführungsformen zu. Eine davon ist schematisch in der Zeichnung anhand mehrerer Figuren dargestellt und nachfolgend beschrieben. Es zeigt:
- Fig. 1: ein erstes Ausführungsbeispiel mit einem pnp-Transistor als Stromquelle,
- Fig. 2: ein zweites Ausführungsbeispiel mit einem npn-Transistor als Stromquelle,
- Fig. 3: eine erste Schaltungsanordnung zur Erzeugung des weiteren Potentials und
- Fig. 4: eine zweite Schaltungsanordnung zur Erzeugung des weiteren Potentials.

Gleiche Teile sind in den Figuren mit gleichen Bezugszeichen versehen.

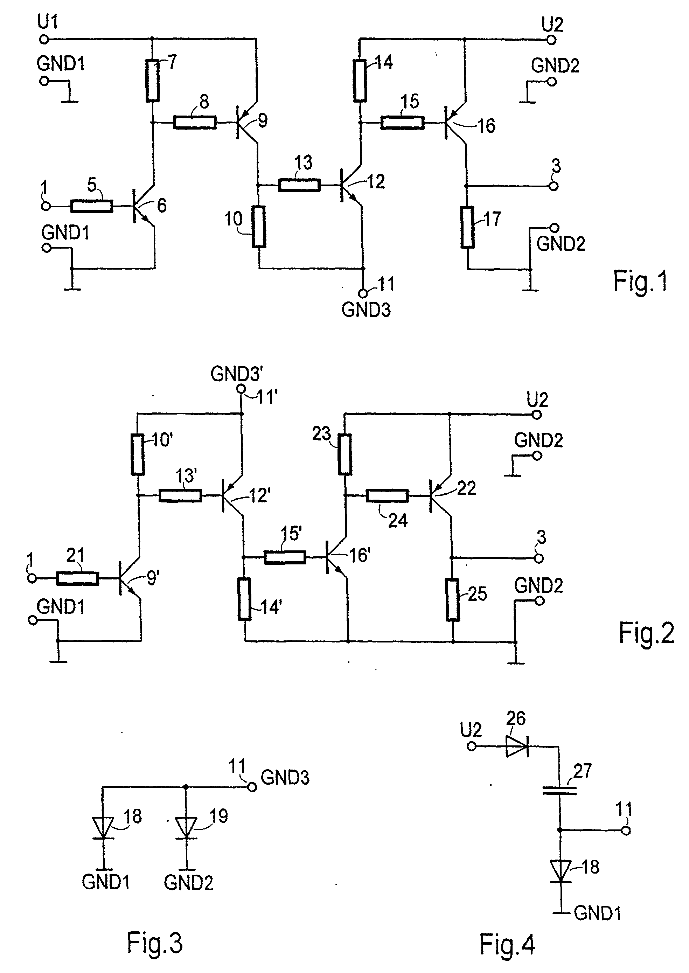

Die in den Figuren 1 und 2 dargestellten Schaltungsanordnungen können sowohl zusätzlich zwischen an sich vollständige Baugruppen eingefügt werden, wie beispielsweise Steuergeräte und Endstufen, als auch Teile der zu verbindenden Schaltungen sein. Die Ausführung als zusätzliche Schaltung ist beispielsweise vorzusehen, wenn ein ansonsten fertiges Steuergerät, das beispielsweise als integrierte Schaltung ausgeführt ist, eine Gegentaktendstufe aufweist. Der Übersichtlichkeit halber sind in den Figuren 1 und 2 die erfindungsgemäßen Schaltungsanordnungen unabhängig von den jeweils zu verbindenden Schaltungen dargestellt.

Das von einer ersten Schaltung abgegebene Signal wird einem Eingang 1 zugeführt und ist auf eine Masse GND1 bezogen. Wie die erste nicht dargestellte Schaltung erhält der dieser ersten Schaltung zugeordnete Teil der erfindungsgemäßen Schaltungsanordnung über einen Anschluß 2 eine Betriebsspannung U1, die ebenfalls auf das Massepotential GND1 bezogen ist. Ein Ausgang 3 ist an die ebenfalls nicht dargestellte zweite Schaltung anschließbar und führt ein Ausgangssignal, das auf Massepotential GND2 der zweiten Schaltung bezogen ist. Ferner ist die dargestellte Schaltungsanordnung über einen Anschluß 4 mit der Betriebsspannung U2 der zweiten Schaltung verbunden.

Bei dem Ausführungsbeispiel nach Fig. 1 gelangt das bei 1 zugeführte Signal über einen Widerstand 5 zu einem Transistor 6, an dessen Arbeitswiderstand 7 das Signal in invertierter Form ansteht. Über einen weiteren Widerstand 8 ist dann ein Transistor 9 angeschlossen, der zusammen mit dem Widerstand 13 eine Stromquelle für den Basisstrom des Transistors 12 bildet. Ein Widerstand 10 stellt sicher, daß bei Sperrung des Transistors 9 der Transistor 12 ebenfalls gesperrt ist. Der Transistor 12 bildet zusammen mit einem Widerstand 15 eine weitere Stromquelle, die von dem Kollektorstrom des Transistors 9 gesteuert wird. Ein Widerstand 14 dient zur sicheren Sperrung des Transistors 16 bei nichtleitendem Transistor 12. Der Kollektorstrom des Transistors 16 bewirkt einen Spannungsabfall am Arbeitswiderstand 17, der als Ausgangssignal dem Ausgang 3 entnommen werden kann.

Wird nun sichergestellt, daß für jeden auftretenden Potentialunterschied zwischen GND1 und GND2 das Potential GND3 einen Wert aufweist, der einen Stromfluß durch die Transistoren 9 und 12 ermöglicht, kann auch eine Übertragung der vorzugsweise digitalen Signale erfolgen. Insbesondere muß das Potential GND2 mindestens um die Summe aus der Emitter-Kollektor-Spannung des Transistors 9 und der Basis-Emitter-Spannung des Transistors 12 niedriger als die Betriebsspannung U1 und mindestens um die Summe der Kollektor-Emitter-Spannung des Transistors 12 und der Basis-Emitter-Spannung des Transistors 16 niedriger als die Betriebsspannung U2 sein.

Um eine Übertragung mit der an sich gewünschten Amplitude der digitalen Signale sicherzustellen, die weitgehend der Betriebsspannung entspricht, ist jedoch ein Potential GND3 erforderlich, das im wesentlichen nicht oberhalb des jeweils niedrigsten der Massepotentiale GND1 und GND2 liegt. Ein solches Potential kann mit der Schaltungsanordnung nach Fig. 3 erzeugt werden, die von zwei Dioden 18, 19 gebildet wird, die jeweils zwischen GND1 bzw. GND2 und dem Schaltungspunkt 11 angeordnet sind.

Bei der Schaltungsanordnung nach Fig. 2 ist der Eingang 1 über einen Widerstand 21 mit einem als Stromquelle arbeitenden npn-Transistor 9' verbunden. Der Spannungsabfall an dessen Arbeitswiderstand 10' steuert die vom Transistor 12' gebildete weitere Stromquelle über einen Widerstand 13'. Am Arbeitswiderstand 14' der weiteren Stromquelle ist dann über einen Widerstand 15' das auf das Massepotential GND2 bezogene Signal abnehmbar, das über Transistoren 16' und 22, die mit Widerständen 23, 24, 25 versehen sind, dem Ausgang 3 zugeführt wird. Das weitere Potential GND3' wird bei 11' zugeführt und soll mindestens um die oben angegebenen Unterschiede über den beiden Massepotentialen GND1 und GND2 liegen, vorzugsweise jedoch mindestens etwa so hoch wie die jeweils höchste Betriebsspannung sein.

Bei einer Anwendung der erfindungsgemäßen Schaltungsanordnung im Kraftfahrzeug kann die Betriebsspannung U2 kurzzeitig ausfallen. Damit beim Wiedereinsetzen der Betriebsspannung Leistungsendstufen, die ebenfalls mit U2 betrieben werden, möglichst schnell wieder angesteuert werden können, ist zur Erzeugung des Potentials GND3 eine Schaltung gemäß Fig. 4 vorgesehen. Bei dieser wird dem Schaltungspunkt 11 einerseits wie bei der Schaltung nach Fig. 3 das Massepotential GND1 über eine Diode 18 zugeführt und andererseits die Betriebsspannung U2 über eine Diode 26 und einen Kondensator 27. Dadurch wird bewirkt, daß während des Aussetzens von U2 GND3 einen im Kondensator 27 gespeicherten negativen Wert annimmt, so daß die Stromquelle 12 auch bei fehlender Betriebsspannung U2 Signale weiterleitet, die dann sofort nach Wiedereinsetzen der Betriebsspannung U2 über den Transistor 16 zum Ausgang 3 weitergeleitet werden.

## Patentansprüche

1. Verfahren zur Übertragung von Signalen von einem Ausgang einer ersten Schaltung zu einem Eingang einer zweiten Schaltung, wobei die Schaltungen von einer ersten und einer zweiten Betriebsspannung und einem ersten und einem zweiten Massepotential beaufschlagt sind und wobei zwischen den Massepotentialen veränderliche Potentialunterschiede auftreten können, dadurch gekennzeichnet, daß vom Ausgang der ersten Schaltung ein von dem zu übertragenden Signal gesteuerter Strom zu einem mit einem weiteren Potential beaufschlagten Schaltungspunkt fließt und einen von dem Schaltungspunkt ausgehenden weiteren Strom steuert, der dem Eingang der zweiten Schaltung zugeführt wird, und daß das weitere Potential derart gewählt ist, daß zwischen dem Ausgang der ersten Schaltung und dem weiteren Potential einerseits und dem weiteren Potential und dem Eingang der zweiten Schaltung andererseits bei den auftretenden Potentialunterschieden jeweils eine den Strom und den weiteren Strom ermöglichende Spannung anliegt.

2. Schaltungsanordnung zur Übertragung von Signalen von einem Ausgang einer ersten Schaltung zu einem Eingang einer zweiten Schaltung, wobei die Schaltungen von einer ersten und einer zweiten Betriebsspannung und einem ersten und einem zweiten Massepotential beaufschlagt sind und wobei zwischen den Massepotentialen veränderliche Potentialunterschiede auftreten können, dadurch gekennzeichnet,
daß der Ausgang der ersten Schaltung mit einer steuerbaren Stromquelle (9, 13; 9', 13') versehen ist, deren Strom in Richtung auf einen mit einem weiteren Potential beaufschlagten Schaltungspunkt fließt und eine an den Schaltungspunkt (11, 11') angeschlossene weitere Stromquelle (12, 15; 12', 15') steuert, deren Strom in Richtung auf den Eingang der weiteren Schaltung fließt, und daß das weitere Potential derart gewählt ist, daß zwischen dem Ausgang der ersten Schaltung und dem weiteren Potential einerseits und dem weiteren Potential und dem Eingang der zweiten Schaltung andererseits bei den auftretenden Potentialunterschieden jeweils eine den Strom und den weiteren Strom ermöglichende Spannung anliegt.

3. Schaltungsanordnung nach Anspruch 2, dadurch gekennzeichnet, daß das weitere Potential (GND3) mindestens um die Summe aus der Emitter-Kollektor-Spannung eines die Stromquelle mindestens teilweise bildenden und mit seinem Emitter mit der ersten Betriebsspannung beaufschlagten Transistors (9) und der Basis-Emitter-Spannung eines die weitere Stromquelle mindestens teilweise bildenden Transistors (12) niedriger als die erste Betriebsspannung und mindestens um die Summe der Kollektor-Emitter-Spannung des die weitere Stromquelle bildenden Transistors (12) und der Basis-Emitter-Spannung eines mit dem Eingang der zweiten Schaltung verbundenden Transistors (16) niedriger als die zweite Betriebsspannung ist.

4. Schaltungsanordnung nach Anspruch 2, dadurch gekennzeichnet, daß das weitere Potential (GND3) mindestens um die Summe aus der Emitter-Kollektor-Spannung eines die Stromquelle mindestens teilweise bildenden und mit seinem Emitter mit dem ersten Massepotential beaufschlagten Transistors (9') und der Basis-Emitter-Spannung eines die weitere Stromquelle mindestens teilweise bildenden Transistors (12') höher als das erste Massepotential und mindestens um die Summe der Kollektor-Emitter-Spannung des die weitere Stromquelle bildenden Transistors (12') und der Basis-Emitter-Spannung eines mit dem Eingang der zweiten Schaltung verbundenden Transistors (16') höher als das zweite Massepotential ist.

5. Schaltungsanordnung nach Anspruch 2, dadurch gekennzeichnet, daß die Betriebsspannungen positiv gegenüber den Massepotentialen sind, daß die Stromquelle der ersten Schaltung einen pnp-Transistor (9) aufweist und mit der ersten Betriebsspannung beaufschlagt ist, daß der Eingang der zweiten Schaltung einen mit der zweiten Betriebsspannung beaufschlagten Widerstand (14) aufweist und daß das weitere Potential im wesentlichen des am stärksten negativen der Massepotentiale entspricht.

6. Schaltungsanordnung nach Anspruch 2, dadurch gekennzeichnet, daß die Betriebsspannungen positiv gegenüber den Massepotentialen sind, daß die Stromquelle der ersten Schaltung einen npn-Transistor (9') aufweist und mit dem ersten Massepotential beaufschlagt ist, daß der Eingang der zweiten Schaltung einen mit dem zweiten Massepotential beaufschlagten Widerstand (14') aufweist und daß das weitere Potential im wesentlichen der am stärksten positiven der Betriebsspannungen entspricht.

7. Schaltungsanordnung nach Anspruch 2, dadurch gekennzeichnet, daß die Betriebsspannungen negativ gegenüber den Massepotentialen sind, daß die Stromquelle der ersten Schaltung einen npn-Transistor aufweist und mit der ersten Betriebsspannung beaufschlagt ist, daß der Eingang der zweiten Schaltung einen mit der zweiten Betriebsspannung beaufschlagten Widerstand aufweist und daß das weitere Potential im wesentlichen des am stärksten positiven der Massepotentiale entspricht.

8. Schaltungsanordnung nach Anspruch 2, dadurch gekennzeichnet, daß die Betriebsspannungen negativ gegenüber den Massepotentialen sind, daß die Stromquelle der ersten Schaltung einen pnp-Transistor aufweist und mit dem ersten Massepotential beaufschlagt ist, daß der Eingang der zweiten Schaltung einen mit dem zweiten Massepotential beaufschlagten Widerstand aufweist und daß das weitere Potential im wesentlichen der am stärksten negativen der Betriebsspannungen entspricht.

9. Schaltungsanordnung nach einem der Ansprüche 2 bis 8, dadurch gekennzeichnet, daß zur Erzeugung des weiteren Potentials ein das weitere Potential führender Schaltungspunkt (11) über je eine Diode (18, 19) mit den Massepotentialen (GND1, GND2) bzw. den Betriebsspannungen beaufschlagt ist.

10. Schaltungsanordnung nach einem der Ansprüche 2 bis 8, dadurch gekennzeichnet, daß zur Erzeugung des weiteren Potentials ein das weitere Potential führender Schaltungspunkt (11) über einen Kondensator (27) und eine erste Diode (26) mit der Betriebsspannung einer der Schaltungen und über eine zweite Diode (18) mit dem Massepotential der anderen Schaltung verbunden ist.

11. Schaltungsanordnung nach einem der Ansprüche 2 bis 10, dadurch gekennzeichnet, daß die erste Schaltung eine Steuerschaltung und die zweite Schaltung eine Leistungsstufe einer elektronischen Kraftfahrzeugeinrichtung ist.

## Claims

1. Method for transmitting signals from an output of a first circuit to an input of a second circuit, the circuits having a first and a second operating voltage and a first and a second earth potential applied to them, and it being possible for variable potential differences to occur between the earth potentials, characterized in that a current controlled by the signal which is to be transmitted flows from the output of the first circuit to a circuit point having a further potential applied to it and controls a further current which starts from the circuit point and is supplied to the input of the second circuit, and in that the further potential is chosen in such a way that a voltage enabling the current and the further current is in each case, present between the output of the first circuit and the further potential, on the one hand, and between the further potential and the input of the second circuit, on the other, for the potential differences that occur.

2. Circuit arrangement for transmitting signals from an output of a first circuit to an input of a second circuit, the circuits having a first and a second operating voltage and a first and a second earth potential applied to them, and it being possible for variable potential differences to occur between the earth potentials, characterized in that the output of the first circuit is provided with a controllable current source (9, 13; 9', 13') whose current flows in the direction of a circuit point having a further potential applied to it and controls a further current source (12, 15; 12', 15') which is connected to the circuit point (11, 11') and whose current flows in the direction of the input of the further circuit, and in that the further potential is chosen in such a way that a voltage enabling the current and the further current is in each case present between the output of the first circuit and the further potential, on the one hand, and between the further potential and the input of the second circuit, on the other, for the potential differences that occur.

3. Circuit arrangement according to Claim 2, characterized in that the further potential (GND3) is lower than the first operating voltage at least by the sum of the emitter/collector voltage of a transistor (9) which at least partly forms the current source and whose emitter has the first operating voltage applied to it, and the base/emitter voltage of a transistor (12) which at least partly forms the further current source, and is lower than the second operating voltage at least by the sum of the collector/emitter voltage of the transistor (12) which forms the further current source, and the base/emitter voltage of a transistor (16) which is connected to the input of the second circuit.

4. Circuit arrangement according to Claim 2, characterized in that the further potential (GND3) is higher than the first earth potential at least by the sum of the emitter/collector voltage of a transistor (9') which at least partly forms the current source and whose emitter has the first earth potential applied to it, and the base/emitter voltage of a transistor (12') which at least partly forms the further current source, and is higher than the second earth potential at least by the sum of the collector/emitter voltage of the transistor (12') which forms the further current source, and the base/emitter voltage of a transistor (16') which is connected to the input of the second circuit.

5. Circuit arrangement according to Claim 2, characterized in that the operating voltages are positive with respect to the earth potentials, in that the current source for the first circuit has a pnp-transistor (9) and has the first operating voltage applied to it, in that the input of the second circuit has a resistor (14) which has the second operating voltage applied to it, and in that the further potential essentially corresponds to the most negative of the earth potentials.

6. Circuit arrangement according to Claim 2, characterized in that the operating voltages are positive with respect to the earth potentials, in that the current source for the first circuit has an npn-transistor (9') and has the first earth potential applied to it, in that the input of the second circuit has a resistor (14') which has the second earth potential applied to it, and in that the further potential essentially corresponds to the most positive of the operating voltages.

7. Circuit arrangement according to Claim 2, characterized in that the operating voltages are negative with respect to the earth potentials, in that the current source for the first circuit has an npn-transistor and has the first operating voltage applied to it, in that the input of the second circuit has a resistor which has the second operating voltage applied to it, and in that the further potential essentially corresponds to the most positive of the earth potentials.

8. Circuit arrangement according to Claim 2, characterized in that the operating voltages are negative with respect to the earth potentials, in that the current source for the first circuit has a pnp-transistor and has the first earth potential applied to it, in that the input of the second circuit has a resistor which has the second earth potential applied to it, and in that the further potential essentially corresponds to the most negative of the operating voltages.

9. Circuit arrangement according to one of Claims 2 to 8, characterized in that, in order to produce the further potential, a circuit point (11) which carries the further potential has the earth potentials (GND1, GND2) or the operating voltages applied to it via a respective diode (18, 19).

10. Circuit arrangement according to one of Claims 2 to 8, characterized in that, in order to produce the further potential, a circuit point (11) which carries the further potential is connected to the operating voltage of one of the circuits via a capacitor (27) and a first diode (26), and to the earth potential of the other circuit via a second diode (18).

11. Circuit arrangement according to one of Claims 2 to 10, characterized in that the first circuit is a control circuit and the second circuit is a power stage in an electronic motor vehicle device.

## Revendications

1. Procédé pour le transfert de signaux d'une sortie d'un premier circuit vers une entrée d'un second circuit, les circuits étant alimentés par une première et une seconde tension de fonctionnement et par un premier et un second potentiel de masse et des différences de potentiels variables pouvant se présenter entre les potentiels des masses, caractérisé en ce qu'un courant contrôlé par le signal à transférer circule de la sortie du premier circuit vers un point du circuit alimenté par un autre potentiel et contrôle un autre courant, partant du point du circuit, qui est amené à l'entrée du second circuit, et en ce que l'autre potentiel est choisi de telle sorte que lorsque des différences de potentiels se présentent, il existe chaque fois une tension permettant la circulation du courant et de l'autre courant entre la sortie du premier circuit et l'autre potentiel d'une part, et entre l'autre potentiel et l'entrée du second circuit d'autre part.

2. Circuit pour le transfert de signaux d'une sortie d'un premier circuit vers une entrée d'un second circuit, les circuits étant alimentés par une première et une seconde tension de fonctionnement et par un premier et un second potentiel de masse et des différences de potentiels variables pouvant se présenter entre les potentiels des masses, caractérisé en ce que la sortie du premier circuit est pourvue d'une source de courant contrôlable (9, 13 ; 9', 13') dont le courant circule en direction d'un point du circuit alimenté par un autre potentiel et contrôle une autre source de courant (12, 15 ; 12', 15') raccordée au point du circuit (11, 11') dont le courant circule en direction de l'entrée de l'autre circuit, et en ce que l'autre potentiel est choisi de telle sorte que lorsque des différences de potentiels se présentent, il existe chaque fois une tension permettant le courant et l'autre courant entre la sortie du premier circuit et l'autre potentiel d'une part, et entre l'autre potentiel et l'entrée du second circuit d'autre part.

3. Circuit selon la revendication 2, caractérisé en ce que l'autre potentiel (GND3) est inférieur à la première tension de fonctionnement d'au moins la somme de la tension émetteur-collecteur d'un transistor (9) constituant au moins partiellement la source de courant, son émetteur étant alimenté par la première tension de fonctionnement, et de la tension base-émetteur d'un transistor (12) constituant au moins partiellement l'autre source de courant, et est inférieur à la seconde tension de fonctionnement d'au moins la somme de la tension collecteur-émetteur du transistor (12) constituant l'autre source de courant, et de la tension base-émetteur d'un transistor (16) relié à l'entrée du second circuit.

4. Circuit selon la revendication 2, caractérisé en ce que l'autre potentiel (GND3) est supérieur au premier potentiel de masse d'au moins la somme de la tension émetteur-collecteur d'un transistor (9') constituant au moins partiellement la source de courant, son émetteur étant alimenté par le premier potentiel de masse, et de la tension base-émetteur d'un transistor (12') constituant au moins partiellement l'autre source de courant, et est supérieur au second potentiel de masse d'au moins la somme de la tension collecteur-émetteur du transistor (12') constituant l'autre source de courant, et de la tension base-émetteur d'un transistor (16') relié à l'entrée du second circuit.

5. Circuit selon la revendication 2, caractérisé en ce que les tensions de fonctionnement sont positives par rapport aux potentiels des masses, en ce que la source de courant du premier circuit comporte un transistor pnp (9) et est alimentée par la première tension de fonctionnement, en ce que l'entrée du second circuit comporte une résistance (14) alimentée par la seconde tension de fonctionnement, et en ce que l'autre potentiel correspond essentiellement au potentiel de masse le plus négatif.

6. Circuit selon la revendication 2, caractérisé en ce que les tensions de fonctionnement sont positives par rapport aux potentiels des masses, en ce que la source de courant du premier circuit comporte un transistor npn (9') et est alimentée par le premier potentiel de masse, en ce que l'entrée du second circuit comporte une résistance (14') alimentée par le second potentiel de masse, et en ce que l'autre potentiel correspond essentiellement à la tension de fonctionnement la plus positive.

7. Circuit selon la revendication 2, caractérisé en ce que les tensions de fonctionnement sont négatives par rapport aux potentiels des masses, en ce que la source de courant du premier circuit comporte un transistor npn et est alimentée par la première tension de fonctionnement, en ce que l'entrée du second circuit comporte une résistance alimentée par la seconde tension de fonctionnement, et en ce que l'autre potentiel correspond essentiellement au potentiel de masse le plus positif.

8. Circuit selon la revendication 2, caractérisé en ce que les tensions de fonctionnement sont négatives par rapport aux potentiels des masses, en ce que la source de courant du premier circuit comporte un transistor pnp et est alimentée par le premier potentiel de masse, en ce que l'entrée du second circuit comporte une résistance alimentée par le second potentiel de masse, et en ce que l'autre potentiel correspond essentiellement à la tension de fonctionnement la plus négative.

9. Circuit selon l'une des revendications 2 à 8, caractérisé en ce que pour générer l'autre potentiel, un point du circuit (11) acheminant l'autre potentiel est alimenté à travers une diode respective (18, 19) par les potentiels des masses (GND1, GND2), ou selon le cas les tensions de fonctionnement.

10. Circuit selon l'une des revendications 2 à 8, caractérisé en ce que pour générer l'autre potentiel, un point du circuit (11) acheminant l'autre potentiel est relié à travers un condensateur (27) et une première diode (26) à la tension de fonctionnement d'un des circuits et à travers une seconde diode (18) au potentiel de masse de l'autre circuit.

11. Circuit selon l'une des revendications 2 à 10, caractérisé en ce que le premier circuit est un circuit de contrôle et le second circuit un étage de puissance d'un équipement électronique d'une automobile.
